# EUROPEAN PATENT APPLICATION

(11) **EP 1 705 803 A1**
(43) Date of publication of application: **27.09.2006**
(21) Application number: 05814757.0
(22) Date of filing: 09.12.2005
(51) Int. Cl.: H04B 1/18, H04N 5/44, H04B 1/10

(54) **TURNER, AND MOBILE DEVICE USING THE SAME**

(30) Priority: 17.01.2005 JP 2005008794
(71) Applicant: MATSUSHITA ELECTRIC INDUSTRIAL CO., LTD., Osaka 571-8501 (JP)
(72) Inventor: MIYAKE, Eiji, Matsushita IMP Bldg.,3-7,Shiromi 1-chome (JP); ADACHI, Kenji, Matsushita IMP Bldg.,3-7,Shiromi 1-chome (JP); OZEKI, Hiroaki, Matsushita IMP Bldg.,3-7,Shiromi 1-chome (JP); ASAYAMA, Osamu, Matsushita IMP Bldg.,3-7,Shiromi 1-chome (JP)
(74) Representative: Grünecker, Kinkeldey, Stockmair & Schwanhäusser Anwaltssozietät
(86) International application number: PCT/JP2005/022645
(87) International publication number: WO 2006/075465

(57) **Abstract**

A tuner includes an input terminal operable to receive a high-frequency signal including a first high-frequency signal and a second high-frequency signal. The second high-frequency signal has a level larger than that of the first signal. The tuner further includes a first filter having an input port coupled to the input terminal for allowing a signal having the first frequency to pass therethrough and for attenuating a signal having the second frequency, a high-frequency amplifier coupled to an output port of the first filter, a second filter having an input port coupled to an output of the high-frequency amplifier for allowing a signal having the first frequency to pass therethrough and for attenuating the signal having the second frequency, a local oscillator, and a mixer for mixing the output of the high-frequency amplifier with an output of the local oscillator. This tuner has a high receiving sensitivity even when the tuner receives a high-power interference signal near a receiving range thereof and in a weak electric field.

## Description

### TECNICAL FIELD

The present invention relates to a tuner for receiving high-frequency signals in broadcast waves, and to a portable device including the tuner.

### BACKGROUND OF THE INVENTION

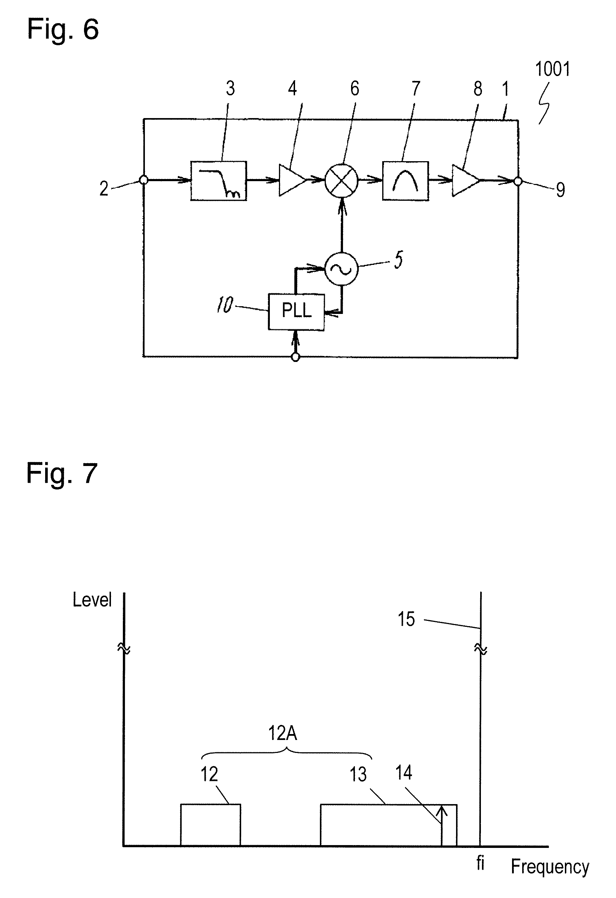

Fig. 6 is a block diagram of conventional tuner 1001 disclosed in Japanese Patent Laid-Open Publication No.2000-13357. Tuner 1001 includes input terminal 2 for receiving signals in a television broadcast wave band, input filter 3 for allowing the input signals to pass through the filter, high-frequency amplifier 4 connected to an output of input filter 3, local oscillator 5, mixer 6 for mixing an output of amplifier 4 with an output of local oscillator 5 and outputting signals in an intermediate-frequency (IF) band, IF filter 7 connected to an output of mixer 6, IF amplifier 8 connected to an output of IF filter 7, output terminal 9 connected to an output of IF amplifier 8, and phase locked loop (PLL) circuit 10 connected to local oscillator 5. As shown in Fig. 6, these components are accommodated in metallic case 1.

A portable device includes tuner 1001 accommodated in a case including a portable telephone. Fig. 7 shows signals in television broadcast waves and an interference signal. VHF broadcast waves 12 and UHF broadcast waves 13 in television broadcast waves 12A are input into input terminal 2 of the tuner. The frequency of maximum-frequency channel 14 in UHF broadcast waves 13 is 707MHz. Transmission wave 15 having a frequency of 830MHz transmitted from the portable telephone is provided over maximum-frequency channel 14. Transmission wave 15 has a level of about +10dBm, which is significantly larger than the levels of broadcast waves 12 and 13, and thus becoming an interference signal for tuner 1001.

In order to remove transmission signal 15, the interference signal, and to receive waves from channel 14, filter 3 has an attenuating property not less than 65dB. After the output of filter 3 is amplified by amplifier 4, a desired broadcast wave is selected from the output of filter 3 by local oscillator 5 and mixer 6. The desired broadcast wave is supplied from output terminal 9, via IF filter 7 and IF amplifier 8. The signal supplied from output terminal 9 is demodulated and displayed on a display via an image processor.

Transmission wave 15, the interference signal for tuner 1001, having a large power exists near UHF broadcast waves 13 to be received, i.e., away from waves 13 by 123MHa. In order to remove this interference signal, filter 3 necessarily have a large attenuation, not less than 65 dB. In order to obtain such a large attenuation, filter 3 has a larger loss, accordingly decreasing its receiving sensitivity.

### SUMMARY OF THE INVENTION

A tuner includes an input terminal operable to receive a high-frequency signal including a first high-frequency signal and a second high-frequency signal. The second high-frequency signal has a level larger than that of the first signal. The tuner further includes a first filter having an input port coupled to the input terminal for allowing a signal having the first frequency to pass therethrough and for attenuating a signal having the second frequency, a high-frequency amplifier coupled to an output port of the first filter, a second filter having an input port coupled to an output of the high-frequency amplifier for allowing a signal having the first frequency to pass therethrough and for attenuating the signal having the second frequency, a local oscillator, and a mixer for mixing the output of the high-frequency amplifier with an output of the local oscillator.

This tuner has a high receiving sensitivity even when the tuner receives a high-power interference signal near a receiving range thereof and in a weak electric field.

### BRIEF DESCRIPTION OF THE DRAWINGS

Fig. 1 is a block diagram of a tuner in accordance with Exemplary Embodiment 1 of the present invention.
Fig. 2 is a block diagram of a portable device in accordance with Exemplary Embodiment 2 of the invention.
Fig. 3 is a block diagram of a portable device in accordance with Exemplary Embodiment 3 of the invention.
Fig. 4 is a block diagram of a portable device in accordance with Exemplary Embodiment 4 of the invention.
Fig. 5 is a block diagram of a portable device in accordance with Exemplary Embodiment 5 of the invention.
Fig. 6 is a block diagram of a conventional tuner.
Fig. 7 shows television broadcast waves and an interference signal.

### REFERENCE NUMERALS

- 12: VHF Broadcast Wave
- 13: UHF Broadcast Wave
- 14: Maximum-Frequency Channel (First High-Frequency Signal)
- 15: Transmission Wave (Second High-Frequency Signal)
- 21: Input Terminal
- 22: Filter (First Filter)
- 23: High-Frequency Amplifier
- 24: Filter (Second Filter)
- 25: Mixer
- 27: Local Oscillator
- 28: Intermediate-Frequency Filter
- 30: Output Terminal
- 32: Case

### DETAILED DESCRIPTION OF PREFERRED EMBODIMENTS EXEMPRALY EMBODIMENT 1

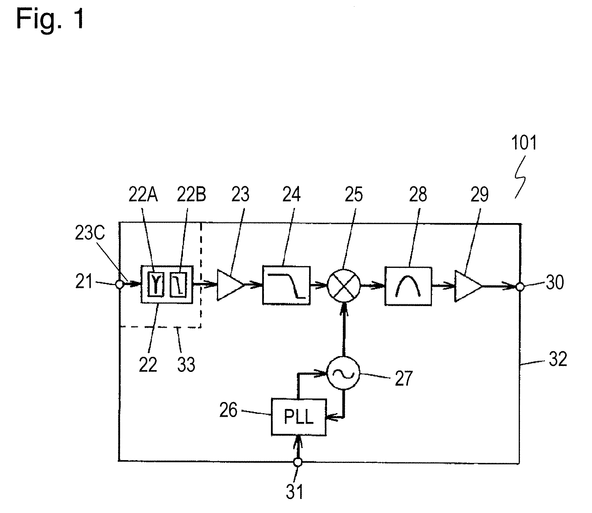

Fig. 1 is a block diagram of tuner 101 in accordance with Exemplary Embodiment 1 of the present invention. Fig. 7 shows television broadcast waves 12A and interference signal 15. Television broadcast waves 12A and interference signal 15 are input into input terminal 21. Television broadcast waves 12A includes VHF broadcast waves 12 and UHF broadcast waves 13. Interference signal 15 has a frequency higher than those of maximum-frequency channel 14. VHF broadcast waves 12 have a frequency band ranging from 90MHz to 220MHz. UHF broadcast waves 13 have a frequency band ranging from 470MHz to 707MHz. The horizontal axis represents frequencies (in MHz), and the vertical axis represents levels (in dB). Interference signal 15 is a transmission wave having frequency fi of 830MHz from a transmitter section of a portable telephone. The level of the transmission signal at input terminal 21 may be not less than +10dBm. Frequency fi of interference signal 15 is very close to the frequency (707MHz) of channel 14 in UHF broadcast waves 13. The interference signal has a extremely large level when the device receives waves of channel 14.

Input terminal 21 is connected to an input of filter 22. Filter 22 allows television broadcast waves 12A to pass through the filter and blocks interference signal 15. An output of filter 22 is connected to an input of high-frequency amplifier 23, and is amplified by high-frequency amplifier 23. An output of high-frequency amplifier 23 is supplied to filter 24. Local oscillator 27 is controlled by phase-locked loop (PLL) circuit 26. Mixer 25 mixes an output of filter 24 with an output of local oscillator 27, and outputs signals in an intermediate-frequency (IF) band.

Filter 22 includes notch filter 22A having an input port connected to input terminal 21, and filter 22B having an input port connected to an output port of notch filter 22A. Filter 22B is a low pass filter. An output port of filter 22B is an output of filter 22, and is connected to the input of high-frequency amplifier 23. Notch filter 22A is also called a trap filter or an absorption filter, and blocks only signals having a predetermined frequency. Filter 22B may be a band pass filter.

Notch filter 22A is formed of a surface acoustic wave (SAW) filter that attenuates a signal having a predetermined frequency only. The frequency matches with frequency fi of interference signal 15. In other words, notch filter 22A attenuates only interference signal 15 in the signals input into input terminal 21. The attenuation of notch filter 22A at frequency fi of interference signal 15 is not less than 40dB.

Filter 22B is mounted on a low-temperature-cofired ceramic (LTCC) substrate. Filter 22B allows signals having frequencies not higher than 707MHz (channel 14) to pass through the filter. The attenuation of filter 22B at 830 MHz is 5dB.

Therefore, the attenuation of filter 22 including notch filter 22A and low pass filter 22B at 830 MHz is not less than 45dB and has a small loss of 1.0dB in its passing frequency band. Filter 22 has an attenuation not less than 45dB at 830 MHz, and reduces the level of signals of 830MHz input into high-frequency amplifier 23 to a level not larger than -35dBm, accordingly preventing the interference signal from entering in high-frequency amplifier 23.

Filter 24 is a low pass filter having an attenuation not less than 25dB at 830MHz in the attenuation band thereof, and having a loss of 2.5dB in its passing frequency band. The attenuation of filter 22 at frequency fi is larger than that of filter 24.

The output of mixer 25 is supplied from output terminal 30 via IF filter 28 and IF amplifier 29. Data input terminal 31 is connected to PLL circuit 26. These circuits are accommodated in metallic case 32, thereby preventing the interference signal input into input terminals 21 from entering the circuits after high-frequency amplifier 23.

Notch filter 22A is provided close to input terminal 21. Notch filter 22A, filter 22, is connected to input terminal 21 with wire 22C having a length not greater one eighth the wavelength of maximum-frequency channel 14 in television broadcast waves. This arrangement prevents the wire provided between notch filter 22A and input terminal 21 from functioning as an antenna, thus preventing the interference signal from being emitted into other circuits at any receiving frequency. The wiring distance between input terminal 21 and notch filter 22A is determined to be shorter than the wiring distance between notch filter 22A and a circuit, i.e., filter 22B according to this embodiment, connected to notch filter 22A.

Interference signal 15 having a large power and input into input terminal 21 can be removed first by notch filter 22A, and is not transferred to circuits provided after low pass filter 22B. Notch filter 22A and low pass filter 22B are surrounded by metallic partition panel 33 and prevents the interference signal from entering into the circuits provided after high-frequency amplifier 23.

According to Embodiment 1, filter 22 and filter 24 are connected to input terminal 21 in series to provide the large attenuation, not less than 65dB, at frequency fi (830MHz) of interference signal 15, thereby allowing signals in the UHF broadcast wave band to pass and attenuating signal 15 of a portable telephone.

Filter 22 has a signal transmission loss (1.0dB) smaller than a loss (2.5dB) of filter 24 provides a large receiving sensibility. Since high-frequency amplifier 23 having a large gain is connected to filter 24, the increase of a noise factor of the tuner caused by the transmission loss of filter 24 is substantially negligible.

The attenuation of filter 22 at frequency fi of interference signal 15 is not less than 40dB, and prevents the output of high-frequency amplifier 23 from being distorted by transmission wave 15. Further, The attenuation of filter 24 at frequency fi not less than 25dB prevents the output of mixer 25 from being distorted by transmission wave 15.

Filters 22 and 24 are connected in series to each other in tuner 101 of Embodiment 1, and provide a total attenuation as the sum of respective attenuations of filters 22 and 24, thus providing a necessary attenuation. The output of high-frequency amplifier 23 is supplied to filter 24, hence allowing the loss of filter 24 to be substantially negligible. This arrangement provides the tuner with its input loss determined by filter 22. The loss of filter 24 is negligible, and accordingly, entire tuner 101 has a small loss and a high receiving sensitivity.

### EXEMPRALY EMBODIMENT 2

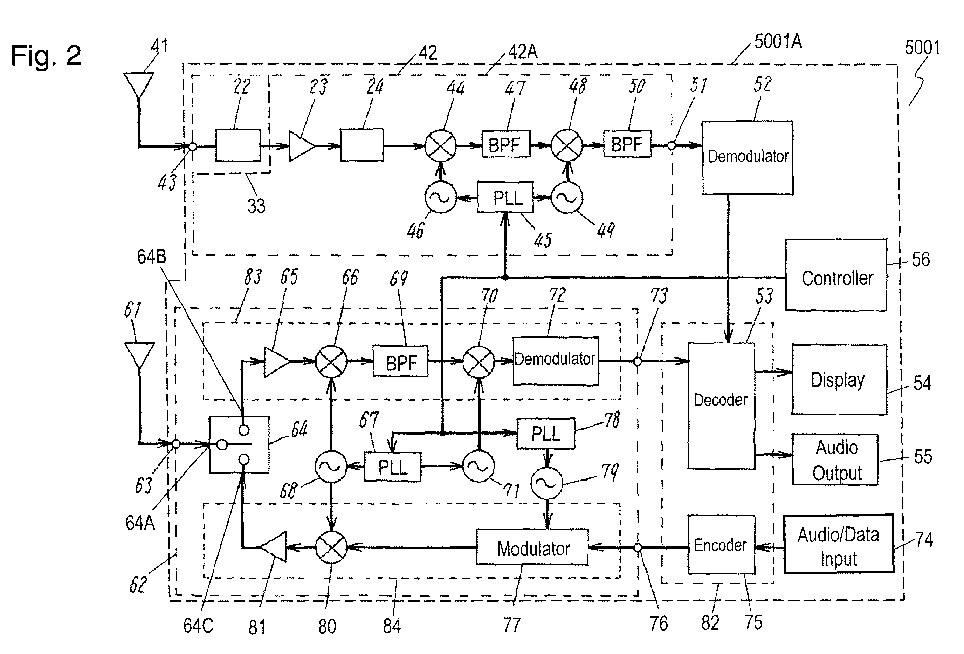

Fig. 2 is a block diagram of portable device 5001 in accordance with Exemplary Embodiment 2. In portable device 5001, a television receiver section including tuner 42 and a portable telephone section are accommodated in case 5001A. Components identical to those of Embodiment 1 are denoted by the same reference numerals, and their description will be simplified.

Television receiving antenna 41 for receiving television broadcast is connected to input terminal 43 of tuner 42. Tuner 42 is accommodated in metallic case 42A. Input terminal 43 is connected to filter 22. Filter 22 is placed close to input terminal 43, that is, is placed from input terminal 43 by a distance not greater than one eighth the wavelength of the receiving frequency. This arrangement prevents interference signal 15 from entering into circuits other than tuner 42. Metallic partition plate 33 surrounding filter 22 prevents interference signal 15 further from entering into the circuits other than tuner 42.

An output of filter 22 is amplified by high-frequency amplifier 23 and output through filter 24. Local oscillator 46 is controlled by PLL circuit 45. Mixer 44 mixes an output of filter 24 with an output of local oscillator 46, and outputs a signal having a first intermediate frequency. A signal supplied from mixer 44 passes through band pass filter 47. Local oscillator 49 is controlled by PLL circuit 45. Mixer 48 mixes an output of band pass filter 47 with and an output of local oscillator 49, and outputs a signal having a second intermediate frequency. A signal supplied from mixer 48 is coupled to output terminal 51 of tuner 42 via band pass filter 50.

Output terminal 51 is connected to display 54, such as a liquid crystal display, via television demodulator 52 and decoder 53. An output of decoder 53 is connected to audio output section 55, such as a speaker or an earphone. PLL circuit 45 is controlled by controller 56. Controller 46 controls PLL circuit 45 to change the frequency of the output of local oscillator 46, thereby performs channel selection. Mixer 48 can perform direct conversion. The television receiver section is structured as above.

Portable telephone antenna 61 for transmitting and receiving signals of a portable telephone is connected to input/output terminal 63 of transmitter/receiver section 62. Input/output terminal 63 is connected to common terminal 64A of antenna switch 64. Terminal 64B of antenna switch 64 is connected to an input port of low-noise amplifier 65. Mixer 66 mixes an output of local oscillator 68 controlled by PLL circuit 67 with an output of low-noise amplifier 65 to convert the frequency of the output of low-noise amplifier 65. An output of mixer 66 is supplied into band pass filter 69.

Mixer 70 mixes an output of local oscillator 71 controlled by PLL circuit 67 with an output of band pass filter 69 to convert the frequency of the output of band pass filter 69. An output of mixer 70 is connected to output terminal 73 of transmitter/receiver section 62 via telephone demodulator 72. Output terminal 73 is connects to display 54 and audio output section 55 via decoder 53.

An output of audio/data input section 74, such as a keyboard and a microphone, is connected to input terminal 76 of transmitter/receiver section 62 via encoder 75. Local oscillator 79 is controlled by PLL circuit 78. Modulator 77 modulates the output of local oscillator 79 with a signal input into input terminal 76, and outputs the modulated signal. Local oscillator 68 is controlled by PLL circuit 67. Mixer 80 mixes an output of modulator 77 with an output of local oscillator 68 to convert the frequency of the output of modulator 77. An output of mixer 80 is connected to terminal 64C of antenna switch 64 via power amplifier 81. Controller 56 controls PLL circuits 67 and 78 as to control the frequency of the outputs of local oscillators 68 and 79 to determine a receiving frequency and a transmitting frequency of the portable telephone section.

Decoder 53 and encoder 75 form signal processor 82. Low-noise amplifier 65, mixers 66 and 70, band pass filter 69, and telephone demodulator 72 provide receiver section 83. Modulator 77, mixer 80, and power amplifier 81 provide transmitter section 84.

Demodulator 53, display 54, and audio output section 55 are shared commonly by the portable telephone section and television receiver section.

A signal input into audio/data input section 74 is encoded by encoder 75. The encoded signal is demodulated by demodulator 77 and mixed by mixer 80, thus providing a carrier wave. The carrier wave is amplified by power amplifier 81 and is emitted from portable telephone antenna 61 as a radio wave.

The level of the emitted radio wave is extremely smaller than the level of a radio wave emitted from a television station. However, television receiving antenna 41 is placed much closer to portable telephone antenna 61 than an antenna of the television station is, accordingly causing the radio wave emitted from the telephone antenna to be a interference signal having a high power for tuner 42. The radio wave emitted from portable telephone antenna 61 has a frequency extremely close to that of maximum-frequency channel 14 in UHF broadcast waves 13, accordingly becoming a large interference signal for tuner 42. In portable device 5001 of Embodiment 2, filter 22 for removing the interference signal is placed close to input terminal 43, accordingly reducing the influence of this interference signal on tuner 42. Therefore, a user can enjoy television broadcasts on the television receiver section with no influence of the portable telephone section accommodated in case 5001A.

### EXEMPLARY EMBODIMENT 3

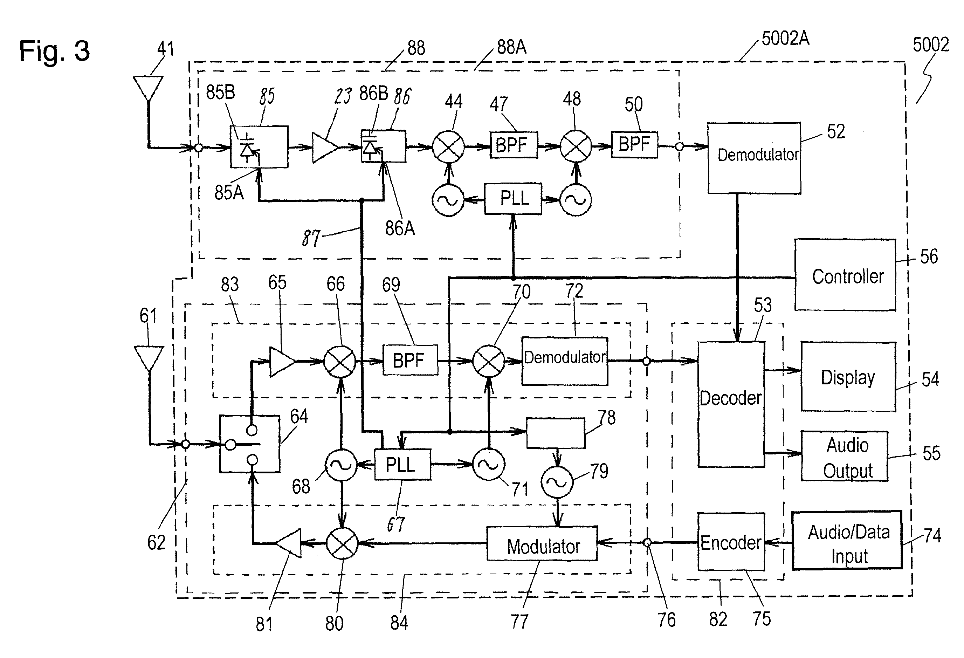

Fig. 3 is a block diagram of portable device 5002 in accordance with Exemplary Embodiment 3. In portable device 5002, a portable telephone section and a television receiver section including tuner 88 are accommodated in case 5002A. Components identical to those of Embodiment 2 are denoted by the same reference numerals, and their descriptions are simplified.

Filters 85 and 86 remove signals having predetermined frequencies controlled with control voltages applied to control terminals 85A and 86A, respectively. An output of PLL circuit 67 is connected via connection line 87 to control terminal 85A of filter 85 and control terminal 86A of filter 86. Filters 85 and 36 include variable capacitance diodes 85B and 86B, respectively. Variable capacitance diodes 85 and 86B function as capacitors providing filters 85 and 86, respectively. Tuner 88 is accommodated in metallic case 88A.

Controller 56 controls PLL circuit 67 to change the frequency of a signal supplied from transmitter section 84, and, according to the frequency, changes attenuation frequencies of filters 85 and 86. That is, even if the frequency of the signal supplied from transmitter section 84 changes, the attenuation frequencies of filters 85 and 86 accordingly change. This operation causes an interference signal having the attenuation frequency to attenuate accurately, accordingly preventing an interference signal from being transmitted to circuits after mixer 44. Thus, tuner 88 can receive television broadcast properly.

### EXEMPLARY EMBODIMENT 4

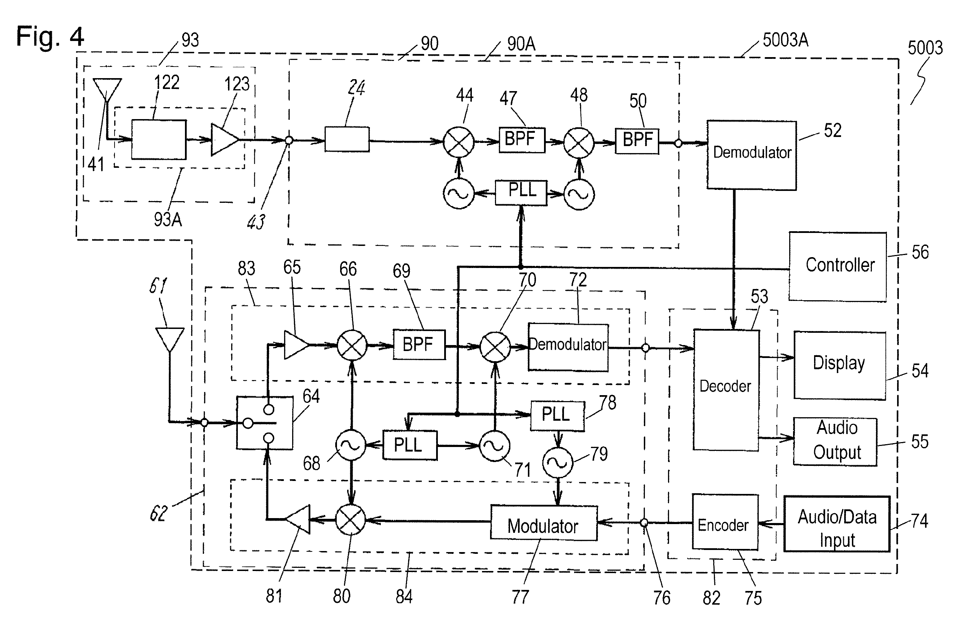

Fig. 4 is a block diagram of portable device 5003 in accordance with Exemplary Embodiment 4. In portable device 5003, a portable telephone section and a television receiver section including tuner 90 are accommodated in case 5003A. Components identical to those of Embodiment 2 are denoted by the same reference numerals, and their descriptions are simplified.

Tuner 90 corresponds to tuner 42 of Embodiment 2 shown in Fig. 2 having filter 22 and high-frequency amplifier 23 eliminated. Input terminal 43 is connected directly to filter 24. The other components are the same as those of tuner 42.

Portable device 5003 includes, instead of filter 22 and high-frequency amplifier 23 of Embodiment 2, filter 122 and high-frequency amplifier 123 having the same functions as filter 22 and high-frequency amplifier 23 of Embodiment 2, respectively. In portable device 5003, filter 122 is connected to television receiving antenna 41 close to filter 122, and an output of filter 122 is connected to input terminal 43 of tuner 90 via high-frequency amplifier 123. Filter 122 and high-frequency amplifier 123 are accommodated in metallic shield case 93A, thus providing antenna block 93. Antenna block 93 is placed close to input terminal 43. Tuner 90 is accommodated in metallic case 90A.

The distance between television antenna 41 and filter 122 is shorter than the distance between high-frequency amplifier 123 and input terminal 43. This arrangement prevents signals emitted from portable telephone antenna 61 from entering into input terminal 43, thus allowing a user to receive television broadcast properly.

### EXEMPLARY EMBODIMENT 5

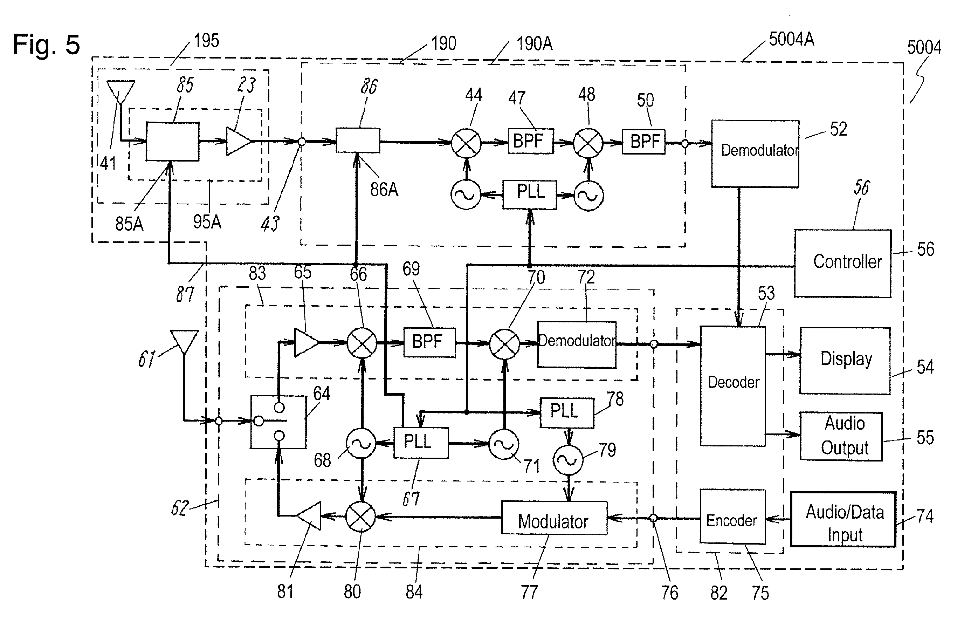

Fig. 5 is a block diagram of portable device 5004 in accordance with Exemplary Embodiment 5. In portable device 5004, a portable telephone section and a television receiver section including tuner 190 are accommodated in case 5004A. Components identical to those of Embodiments 3 and 4 are denoted by the same reference numerals, and their descriptions are simplified.

Portable device 5004 of Embodiment 5 includes antenna block 195 and tuner 190 instead of antenna block 95 and tuner 90 in portable device 5003 of Embodiment 4 shown in Fig. 4. Antenna block 195 includes filter 85 accommodated therein. Tuner 190 includes filter 86. The other components are substantially similar to those of Embodiment 4. Filters 85 and 86 have attenuation frequencies controlled with control voltages applied to control terminals 85A and 86A, respectively. Control terminals 85A and 86A are connected to PLL circuit 67 via connection line 87 for applying the control voltages from PLL circuit 67. Tuner 190 is accommodated in metallic case 190A.

Controller 56 controls PLL circuit 67 to change the frequency of a signal supplied from transmitter section 84, and, according to the frequency, the attenuation frequencies of filters 85 and 86 change. That is, when the frequency of the signal supplied from transmitter section 84 changes, the attenuation frequencies of filters 85 and 86 accordingly change. This operation reduces an influence of a radio wave from transmitter section 84, i.e. an interference signal, thereby allowing the tuner to receive television broadcast properly.

### INDUSTRIAL APPLICABILITY

A tuner according to the present invention removes an interference signal having a large power and having a frequency close to a receiving frequency band, and thereby receives television broadcast waves with a high sensitivity, accordingly being useful as a tuner accommodated in a portable device, such as a portable telephone.

## Claims

1. A tuner comprising:
an input terminal operable to receive a high-frequency signal, the high-frequency signal including a first high-frequency signal and a second high-frequency signal, the second high-frequency signal having a level larger than a level of the first signal;
a first filter having an input port coupled to the input terminal, the first filter allowing a signal having the first frequency to pass therethrough and attenuating a signal having the second frequency;
a high-frequency amplifier coupled to an output port of the first filter;
a second filter having an input port coupled to an output of the high-frequency amplifier, the second filter allowing a signal having the first frequency to pass therethrough and attenuating the signal having the second frequency;
a local oscillator;
a mixer for mixing the output of the high-frequency amplifier with an output of the local oscillator;
an intermediate-frequency filter having an input port coupled to an output of the mixer; and
an output terminal for receiving an output of the intermediate-frequency filter.

2. The tuner of claim 1, further comprising a metallic case for accommodating the first filter, the high-frequency amplifier, the second filter, the local oscillator, the mixer, and the intermediate-frequency filter therein.

3. The tuner of claim 1, wherein the first filter is placed closer to the input terminal than the high-frequency amplifier is.

4. The tuner of claim 1, wherein an attenuation of the first filter at the second frequency is larger than an attenuation of the second filter at the second frequency.

5. The tuner of claim 1, wherein a transmission loss of the first filter at the first frequency is smaller than a transmission loss of the second filter at the first frequency.

6. The tuner of claim 1, wherein the first filter comprises:
a notch filter for attenuating a signal having the second frequency only; and
a low pass filter coupled in series to the notch filter, the low pass filter allowing the signal having the first frequency to pass therethrough and attenuating the signal having the second frequency.

7. The tuner of claim 1, further comprising a metallic partition plate for surrounding the first filter.

8. The tuner of claim 1, further comprising a wire for coupling the input terminal to the first filter, the wire having a length not greater than one eighth a wavelength of the first frequency.

9. A portable device comprising:
an antenna operable to receive a high-frequency signal, the high-frequency signal including a first high-frequency signal and a second high-frequency signal, the second high-frequency signal having a level larger than a level of the first signal,
a tuner including
an input terminal coupled to the antenna,
a first filter having an input port coupled to the input terminal, the first filter allowing a signal having the first frequency to pass therethrough and attenuating a signal having the second frequency,
a high-frequency amplifier coupled to an output port of the first filter,
a second filter having an input port coupled to an output of the high-frequency amplifier, the second filter allowing a signal having the first frequency to pass therethrough and attenuating the signal having the second frequency,
a local oscillator,
a mixer for mixing the output of the high-frequency amplifier with an output of the local oscillator,
an intermediate-frequency filter having an input port coupled to an output of the mixer, and
an output terminal for receiving an output of the intermediate-frequency filter; and
a transmitter section for transmitting the second high-frequency signal.

10. The portable device of claim 9, further comprising a case for accommodating the tuner and the transmitter section.

11. The portable device of claim 9, wherein the first filter and the second filter have passing frequency controlled according to the second frequency.

12. The portable device of claim 11, wherein each of the first filter and the second filter includes a variable capacitance diode.

13. The portable device of claim 9, further comprising a case for accommodating the second filter, the local oscillator, the mixer, the intermediate-frequency filter, and the transmitter section, the case not accommodating the antenna, the input terminal, the first filter, or the high-frequency amplifier.

14. The portable device of claim 13, further comprising a shield case for accommodating the first filter and the high-frequency amplifier.

15. The portable device of claim 14, wherein a distance between the antenna and the first filter is shorter than a distance between the high-frequency amplifier and the input terminal of the tuner.
